# EUROPEAN PATENT APPLICATION

(11) **EP 0 796 932 A1**
(43) Date of publication of application: **24.09.1997**
(21) Application number: 97104890.5
(22) Date of filing: 21.03.1997
(51) Int. Cl.: C30B 25/02, C30B 23/02, C30B 25/14

(54) **Method of compound semiconductor crystal growth amd semicoductor device fabricated thereby**

(30) Priority: 21.03.1996 JP 64163/96
(71) Applicant: NEC CORPORATION, Tokyo (JP)
(72) Inventor: Gomyo, Akiko, Minato-ku, Tokyo (JP); Hotta, Hitoshi, Minato-ku, Tokyo (JP); Miyasaka, Fumihito, Minato-ku, Tokyo (JP)
(74) Representative: Glawe, Delfs, Moll & Partner

(57) **Abstract**

Disclosed herein is a method of semiconductor crystal growth characterized in that a III-V compound semiconductor layer is formed on a semiconductor substrate having a (11n)B, (n= 3, 4, 5, 6, 7 ) surface as a growth plane orientation by a metal organic phase epitaxy ( MOVPE ) method and a ratio of a group V raw material supply to a group III raw material supply ( a V/III ratio ) during growth of the group III-V semiconductor layer is 55 or less. The method is also characterized in that a III-V ccompound semiconductor layer is formed on a semiconductor substrate having a (11n)B surface ( n=3, 4, 5, 6, 7 ) as a growth plane orientation by a molecular beam epitaxial growth method employing group V pressure of 2 × 10⁻⁵ Torr or less during growth of the foregoing III-V compound semiconductor layer. The semiconductor device of the present invention is characterized in that a III-V compound semiconductor layer is formed on a semiconductor substrate having a (11n)B surface ( n=3, 4, 5, 6, 7 )as a growth plane orientation by an MOVPE method and a V/III ratio during growth of the foregoing group III-V semiconductor layer is 55 or less. The semiconductor device of the present invention is also characterized in that a group III-V semiconductor layer is formed on a semiconductor substrate having a (11n)B surface ( n=3, 4, 5, 6, 7 ) as a growth plane orientation by a molecular beam epitaxial growth method with a group V pressure in a growth apparatus of 2 × 10⁻⁵ Torr or less during growth of the foregoing group III-V compound semiconductor layer. According to the crystal manufacturing method of the present invention, step bunching in the quantum well layer formed of the group III-V compound semiconductor alloy crystal on the semiconductor substrate is reduced and the flatness of a quantum well layer can be achieved. Therefore, semiconductor devices using the quantum well structure with superior quantum size effects and characteristics can be obtained. This is advantageous when growing certain compound semiconductors on misoriented substrates so as to suppress natural superlattice formation.

## Description

### BACKGROUND OF THE INVENTION

### 1. Field of the Invention

The present invention relates to an epitaxial growth method of a group III-V compound semiconductor alloy crystal and a manufacturing method of a semiconductor device fabricated using this method. More particularly, the present invention relates to a growth method of a quantum well structure having a flat well/barrier interface and a semiconductor device having improved electrical characteristics using such flat interface quantum wells.

### 2. Description of the Related Art

Semiconductor alloy crystals of AlGaIn having bandgap wavelengths in the visible wavelength regime which matches in lattice constant with a GaAs substrate, and AlGaInAs and GaInAsP alloy crystals having bandgap wavelengths in the long wavelength regime, which matches in lattice constant with that of an InP substrate are being used as an optical as well as an electronic device. In addition, a compressively strained GaInAs formed on GaAs substrates has also been used as anoptical device or an electronic device.

In order to improve the characteristics of semiconductor devices using these materials, the incorporation of quantum well structures is becoming indispensable. A thin film growth technique is needed for manufacturing of the quantum well structure, so that a Metal Organic Vapor Phase Epitaxy method ( hereinafter referred to as an MOVPE method ) or a molecular beam epitaxy method ( hereinafter referred to as an MBE method) has been used.

Furthermore, since the characteristic of a semiconductor device may be further improved by constituting the quantum well structure with a combintion of strained materials, a manufacturing of a strained quantum well structure such as a compressive strain or a tensile strain type quantum wells is been attempted.

On the other hand, in Applied Physics Letters Vol. 50 ( 1987 ) page 673, for example, A. Gomyo et al. have reported that in the group III-V alloy crystal composed of more than three group III elements such as AlGaInP type materials, a natural superlattice is formed depending on growth conditions. Since natural supperlattices are in a more ordered state as compared with ordinary random alloys, its bandgap energy is reduced ssignificantly.

In a light emitting device such as an LED or a semiconductor laser, in order to shorten the light emitting wavelength or the lasing wavelength, it is necessary to render the natural superlattice to be disordered and thus widen the bandgap. As an approach to accomplish this, a method using a misoriented substrate, i.e., a slanted substrate, the surface of which is inclined toward the 〈110〉 direction from a ( 001 ) plane, has been adopted ( K. Kobayashi et al., Japanese Journal Applied Physics Vol.29( 1990 ) page L 1669 ). Furthermore, such growth of the III-V alloy crystal by MOVPE has been conducted under the condition that the ratio of the flow rate of the group V material to that of the group III material ( V/III ratio ) is about 50 to 1500.

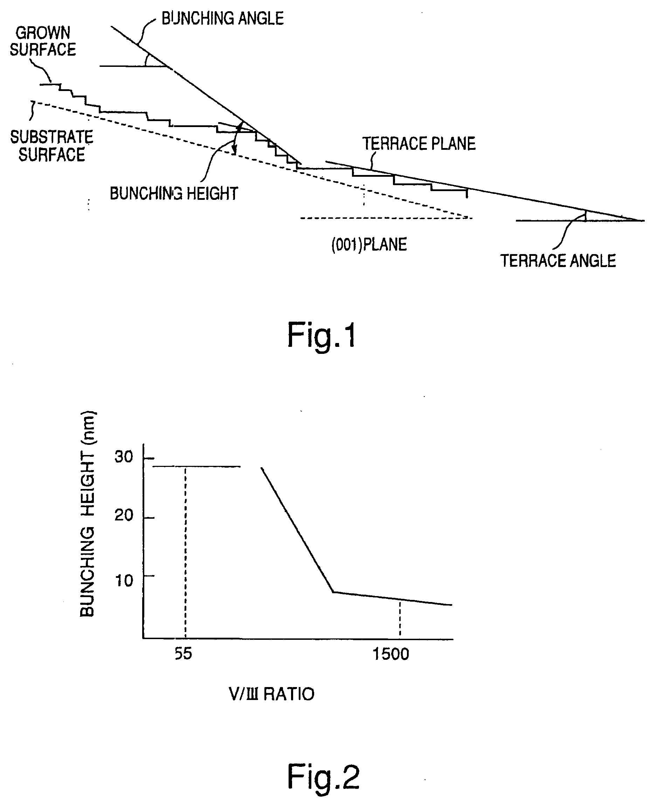

However, when a substrate having a ( 001 ) surface plane or a ( 001 ) to form a semiconductor layer thereon, a so called "step bunching" occurs. Step bunching is the state where macroscopically, the surface of the substrate is oriented to a certain direction, while microscopically, the surface is composed of a series of undulated surfaces resulting in no definite surface orientation. Suck a state is schematically shown in Fig. 1. As shown in Fig. 1, the grown surface comprises a series of undulated surfaces formed because of non-uniformity of intervals between atomic steps, and this phenomenon is called step bunching.

Although it is not the intention of the applicant to be restricted to a particular theory concerning the mechanism of step bunching formation, it is believed to be as follows. The geometrical shape of the step bunching is different depending on the growth conditions. There exists a condition under which the steps becomes localized in order to reduce surface free energy and stabilize the surface during growth causing the step bunching to be significant. In case of the group III-V alloy crystal semiconductor, when the group III-V alloy crystal is epitaxially grown on a misoriented substrate, generation of step bunching is frequently observed.

In the case of a quantum well structure formed of thin film with a thickness of about several nm, when the step bunching occurs, a thickness of the quantum well layer will vary depending on a position in the substrate plane. Since, injected carriers are localized and emit light at a region where the thickness of the quantum well layer is thick and hence the quantum energy level low, the light emission energy is lowered than the value preset by design. This results in a problem that no desired light emission energy can be obtained owing to step bunching generation.

Furthermore, the step bunching tends to become more significant when the off angle (misorientation angle) of the orientation of the substrate plane to be grown from the plane (001) is larger. This tendency will be duscussed in more detail with reference to Fig. 2.

In Fig. 2, a dependence of the height of the step bunching on a V/III ratio during an MOVPE growth is shown, the step bunching being produced in thee group III-V alloy crystal which is grown on a GaAs substrate misoriented from the ( 001 ) plane towards the [110] direction. When the (001) substrate is misoriented towards the [110] plane, the atom step interval on the surface becomes dense. Under the step flow condition where adsorptions of atoms to the step edges occur continuously thereby promoting growth, if the V/III ratio is constant, the percedntage of the V group material to cover the step edges on the substrate surface becomes small in case of a largely misoriented substrate. Therefore, the probability of the adsorption of group V atoms to the step edge is lowered.

Although the step edge to which the group V atoms adsorb grows laterally due to the step flow growth, the step edge to which little or no group V atoms adsorb does not grow laterally, whereby non-uniformity of the step interval is produced on the substrate surface. The non-uniformity of the step interval makes the steps to be multilayered. Thus, the non-uniformity of the step produces the step bunching. Under the same growth condition, the step bunching generally increases as the growth advances.

Here, if the adsorption probability of the group V atoms to the step edge is increased, the non-uniformity of the step interval will not occur, so that the generation of the step bunching as well as an increase thereof can be prevented. However, the increase in the adsorption probability of the group V atoms to the step edge only becomes practical under the growth condition that the V/III ratio exceeds 1000. The relation between the step bunching height and the V/III ratio during growth exhibits a similar trend for a (001) substrate misoriented no more than 10° towards the [110] direction as to that of the (001) substrate.

In general, as the miorientation angle between the substrate surface and the (001) plane becomes larger, a larger V/III ratio is necessary to prevent step bunching to occur. For example, when an AlGnP crystal is grown on a GaAs substrate which is misoriented from the (001) plane by 6° towards the [110] direction, a V/III ratio as large as 1500 is required in order to obtain a flat interface of the quantum well.

These tendencies causes a problem because the natural superlattice has a tendency to be formed more easily when the V/III ratio is large. For example, when a (001) substrate misoriented by 6° towards the [111]A direction is used, a bandgap of a GaInP lattice matched to GaAs decreases from 1.88 eV to 1.86eV, indicative of natural superlattice formation, by increasing the V/III ratio from 130 to 1500. As explained before, the formation of the natural superlattice which has a reduced bandgap is to be avoided, and this was the reason for using misoriented substrates in the first place.

Moreover, the amount of a group V material consumption becomes very large. Safety considerations related to use of hazerdous substances such as arsine and phosphine must be taken into account when the amount of the group V material consumption becomes high. In addition, an increase in cost of the raw materials and an increase in cost in order to enhance the exhaustion ability of the apparatus are brought about. For these reasons, a reduction in the amount of the group V material is desired.

### SUMMARY OF THE INVENTION

It is therefore, an object of the present invention to provide a method of semiconductor crystal growth capable of forming a compound semiconductor layer with less step bunching on a semiconductor substrate so that a semiconductor crystal growth method which is capable of forming a uniform thickness barrier layer and a uniform thickness quantum well layer under growth conditions of a low V/III ratio (in case of MOVPE) and a low group V pressure (in case of MBE). It is another object of the present invention to provide a semiconductor device wherein its characteristics are improved by use of the above semiconductor crystal growth method.

The method of semiconductor crystal growth of the present invention is characterized in that a III-V compound semiconductor layer is formed on a semiconductor substrate having a (11n)B (n=3, 4, 5, 6, 7) surface as a growth plane orientation by a metal organic phase epitaxy (MOVPE) method and a ratio of a group V raw material supply to a group III raw material supply ( a V/III ratio ) during growth of the foregoing group III-V semiconductor layer is 55 or less.

The method of semiconductor crystal growth of the present invention is also characterized in that a III-V ccompound semiconductor layer is formed on a semiconductor substrate having a (11n)B surface (n=3, 4, 5, 6, 7 ) as a growth plane orientation by a molecular beam epitaxial growth method employing group V pressure of 2 × 10⁻⁵ Torr or less during growth of the foregoing III-V compound semiconductor layer.

The semiconductor device of the present invention is characterized in that a III-V compound semiconductor layer is formed on a semiconductor substrate having a (11n)B surface ( n=3, 4, 5, 6, 7 ) as a growth plane orientation by a metal organic phase epitaxy ( MOVPE ) method and a ratio of a group V raw material supply to a group III raw material supply ( a V/III ratio ) during growth of the foregoing group III-V semiconductor layer is 55 or less.

The semiconductor device of the present invention is also characterized in that a group III-V semiconductor layer is formed on a semiconductor substrate having a (11n)B surface ( n=3, 4, 5, 6, 7) as a growth plane orientation by a molecular beam epitaxial growth method with a group V pressure in a growth apparatus of 2 × 10⁻⁵ Torr or less during growth of the foregoing group III-V compound semiconductor layer.

Furthermore, the semiconductor device of the present invention is characterized in that the group III-V compound semiconductor layer includes at least one quantum well structure comprising a barrier layer and a quantum well layer.

Furthermore, the semiconductor device of the present invention is characterized in that the quantum well structure is used as a light emitting layer or an electron channel layer.

Furthermore, the semiconductor device of the present invention is characterized in that GaAs is used as the semiconductor substrate, (AlₓGa₁₋ₓ)_{y}In_{1-y}P is used as the barrier layer, and (Al_{x'}Ga_{1-x'})_{y'}In_{1-y'}P is used as the quantum well layer, where 0≤x<1, 0<x'≤1, 0<y<1, 0<y'<1.

Furthermore, the semiconductor device of the present invention is characterized in that InP is used as the semiconductor substrate, (AlₓGa₁₋ₓ)_{y}InP_{1-y}As is used as the barrier layer, and (Al_{x'}Ga_{1-x'})_{y'}In_{1-y'}As is used as the quantum well layer, where 0≤x<1, 0<x'≤1, 0<y<1, 0<y'<1.

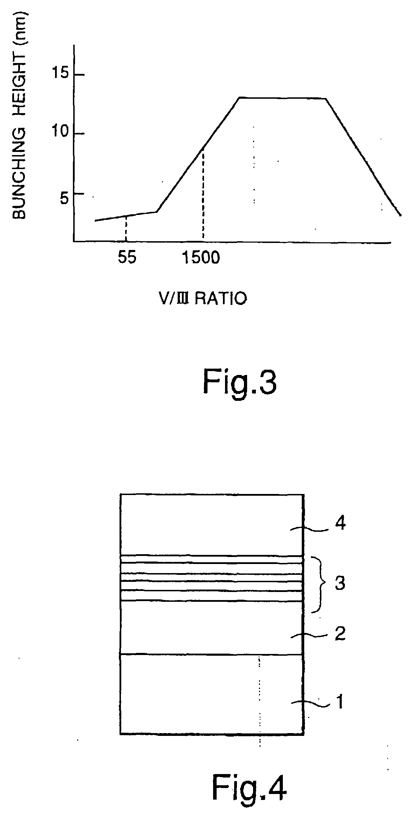

The mechanism through which the present invention is believed to accomplish the above objectives will be described hereinafter. Fig. 3 shows a relation between the V/III ratio and the step bunching height when a III-V compond semiconductor layer is formed by the MOVPE method according to an embodiment of the present invention.

When the (11n)B surface ( n: integers from 3 through 7) is used as the orientation of the substrate surface, its crystallographic plane has a lower index compared with the conventional misoriented substrate with a surface slightly slanted from the (001) surface plane. Therefore, the crystallographic property of the substrate surface is significantly different. For this reason, an epitaxial growth mode also becomes different. Accordingly, the manner in which step bunching is generated also becomes different.

In case of the (11n)B surface, when the V/III ratio is as small as less than 55, the experiments by the present inventors revealed that the step intervals as defined in the case of the (001) surface are uniform. Thus, step bunching hardly occurs because the crystal growth itself proceeds keeping the substrate orientation constant, and the step bunching height does not increase. For this reason, the formation of the semiconductor layer such as the quantum well layer and the barrier layer on a (11n)B surface with the V/III ratio less than 55 permits the formation of a quantum well structure having flat surfaces . Such flat interfaces also provide sharp intrefaces between the quantum well layer and the barrier layer, thus enabling the quantum size effect to be strong.

On the other hand, when the V/III ratio is as large as 1000, step bunching tends to increase somewhat. In this case, the present invention also made it clear that the increase in the step bunching is smaller compared to the case where the substrate is only slightly misoriented from the (001) plane.

The above principle holds for types of materials which lattice matches with the substrate. For example, in the case where GaAs is used as the substrate and an AlGaInP type crystal is formed thereon, or in the case where the InP substrate is used and an AlGaInAs type crystal is formed thereon, or in cases where the InP substrate is used and a GaInAsP type crystal is formed thereon, the same principle holds.

Furthermore, a similar principle holds for materials which do not lattice match with the substrate, and hence are grown with increased step bunching owing to strained layer growth. They are, for example, the AlGaInP type crystal on a GaAs substrate, the GaInAs type crystal on the GaAs substrate, the AlGaInAs type crystal on the InP substrate, the GaInAsP type crystal on the InP substrate, and InAsSb and GaAsSb type crystals on the GaAs or the InP substrate. A reduction in the formation of step bunching and the growth of the film having even thickness suitable for the quantum well structure can be achieved.

In addition, in the case where the MBE method is adopted as the film formation method, it is possible to reduce the step bunching on the substrate (11n)B by keeping the group V growth pressure under 2 × 10⁻⁵ Torr. Moreover, use of the (11n)B surface is advantageous since it is estimated that owning to the difference between the step edge shapes produced when the substrate plane is the (11n)B surface and that produced when it is the (11n)A surface, the adsorption of the group V atoms to the step edge more easily occurs on the (11n)B surface than the (11n)A surface. That is, the prevention of step bunching will be effective at a smaller value of the V/III ratio compared with the case using a (11n)A surface. Here, the V/III ratio in the MBE method is obtained using an internal pressure of the growth chamber for the group V species and a beam flux value measured with an ion gauge for the group III species.

### BRIEF DESCRIPTION OF THE DRAWINGS

The above and other objects, advantages and features of the present invention will be more apparent from the following description taken in conjunction with the accompanying drawing in which:
Fig. 1 is a schematic view showing a state where a step bunching is generated in a semiconductor layer formed on a semiconductor substrate misoriented from a (001) plane towards a [110] direction;
Fig. 2 is a schematic view showing a dependency of a step bunching height on a V/III ratio during MOVPE or MBE growth of a quantum well layer of a group III-V compound semiconductor layer which is formed on a substrate misoriented from a (001) plane towards a [110] direction by 6°;
Fig. 3 is a graph showing a dependency of a step bunching height on a V/III ratio during MOVPE or MBE growth of a quantum well layer of a group III-V compound semiconductor layer formed on a (115)Bplane substrate; and
Fig. 4 is a schematic sectional view showing a layer structure in which clad layers and a multilayer quantum well structure are laminated on a (11n)B plane substrate ( n: integers from 3 through 7).

### DETAILED DESCRIPTION OF THE PREFERRED EMBODIMENTS

An embodiment of the crystal growth method of the present invention will be described hereinbelow with reference to Fig. 4.

### (Example 1)

First, five GaAs substrates having a plane orientation (11n)B, with n being 3, 4, 5, 6, and 7 are simultaneously inserted into an MOVPE reaction chamber as the semiconductor substrate. An( AlₓGa₁₋ₓ )_{y}In_{1-y}P (x = 0.6, y= 0.5 ) clad layer 2 which lattice matches with the GaAs substrates are formed on each of the five GaAs substrates with a thickness of 0.5 µm. Thereafter, a multiple quantum well (MQW) layer 3 composed of four (Al_{0.5}Ga_{0.5} )_{0.5}In_{0.5}P barrier layers each with a thickness of 4nm and five Ga_{0.5}In_{0.5}P quantum well layers each with a thickness of 5nm, and a second clad layer ( AlₓGa₁₋ₓ )_{y}In_{1-y}P 4 as a cap layer are grown with a thickness of 0.5 µm. At this time, a growth temperature, i.e., the temperature of the substrate during growth is 660 °C and a V/III ratio is 55.

While the height of the step bunching in a layer grown conventionally with the V/III ratio of 1500 is 5 to 8 nm, the height of the step bunching in the layer grown by this embodiment is in the range of 3 to 4 nm on the (11n)B, (n=3-7) surface with the V/III ratio of 55. Namely, the height of the step bunching in the layer of this embodiment is reduced to half of the conventional grown layer. Thus, the degree of flatness of the MQW is increased. Photoluminescence characterization of the MQW samples showed that an photoluminescence intensity under argon ion laser excitation increased by about 30 %, that is, output of a photomuliplier increased from 15 to 19 mV. The effective bandgap of the Ga_{0.5}In_{0.5}P quantum well layers was determined to be about 1.90 eV, close to 1.92 eV which corresponds to a disordered crystal, thus indicating that formation of a natural superlattice was prevented.

### (Example 2)

Using the same types of substrates as in Example 1, the increase in the degree of the flatness of a similar quantum well structure is also achieved when the clad layer 2 is formed of Al_{0.5}In_{0.5}P, the MQW 3 composed of three 6 nm thick (Al_{0.7}Ga_{0.3} )_{0.5}In_{0.5}P barrier layers and three 8 nm thick ( Al_{0.1}Ga_{0.9} )_{0.5}In_{0.5}P quantum well layers is laminated thereon, and an Al_{0.5}In_{0.5} P layer as the cap layer 4 is formed at a growth temperature of 660 °C and with a V/III ratio of 40. The height of the step bunching of the ( Al_{0.1}Ga_{0.9} )_{0.5}In_{0.5}P quantum well layer is reduced to a range of 2.5 to 3 nm compared with that of 6 nm, that is, it is reduced to about 50 to 40 % of the prior art case.

### (Example 3)

Five different InP substrates, each having a (11n)B surface with n being 3, 4, 5, 6, and 7 are simultaneously inserted into an MOVPE reaction chamber as the semiconductor substrate. On each of the InP semiconductor substrates, (Al_{0.5}Ga_{0.5})_{0.5}In_{0.5}As clad layer 2 with a thickness of 0.6 µm was formed. Thereafter, a MQW structure 3 composed of three ( Al_{0.3}Ga_{0.7} )_{0.5}In_{0.5}As barrier layers with a thickness of 5nm and five Ga_{0.5}In_{0.5}As quantum well layers with a thickness of 4 nm is formed thereon. An Al_{0.5}In_{0.5}As layer is formed as the cap layer 4 thereon with a thickness of 0.4 µm.

While the step bunching height value obtained by using the the conventional substrate in the MOVPE method was 5 nm, the step bunching height of the quantum well layer of the present embodiment grown with the V/III ratio of 50 at the growth temperature of 600 °C is reduced to 2.5 to 3 nm, which is 40 to 50 % of the conventional value and a light emission efficiency is increased by 20 %.

### (Example 4)

Using the same types of substrates as in Example 3, the increase in the degree of the flatness of a similar quantum well structure is also achieved when a Ga_{x2''}In_{1-x2''}As_{y''}P_{1-y2''} layer (composition x2'' and y2'' determined according to a bandgap corresponding to a wavelength of 1.1 µm ) lattice matching with InP is formed as the clad layer 2 with a thickness of 0.6 µm, an MQW structure 3 composed of four 45 nm thick Ga_{x''}In_{1-x''}As_{y''}P_{1-y''} barrier layers (composition x'' and y'' determined by a bandgap corresponding to a wavelength of 1.3 µm) and five 30 nm thick Ga_{x''}In_{1-x''}As_{y''}P_{1-y''} quantum well layers of (composition x'' and y'' determined by a bandgap corresponding to a wavelength of 1.5 µm) is formed on the clad layer 2. A Ga_{x2''}In_{1-x2''}As_{y2''}P_{1-y2''} layer is formed as the cap layer 4 with a thickness of 0.4 µm. With such a structure, the height of the step bunching in the quantum well layer is reduced to 2.5 nm compared with that of 5 to 6 nm in the conventional quantum well layer. That is, the height of the step bunching is reduced to 50 to 60 % of the prior art. Furthermore, it was shown that a light emission efficiency concerning light emitted from the quantum well layer is increased by about 40 %. In this example, The growth temperature of the layer structure was 620 °C and the V/III ratio was 30.

An embodiment of a semiconductor device of the present invention will now be described using an example of manufacturing a semiconductor laser device. Using an n-type GaAs having a (115)B surface as the semiconductor growth substrate, a Si doped GaAs buffer layer with a thickness of 0.3µm, a Si doped ( Al_{0.7}Ga_{0.3} )_{0.5}In_{0.5}P n-type clad layer with a thickness of 1 µm, a multiple quantum well (MQW) layer composed of four undoped ( Al_{0.5}Ga_{0.5} )_{0.5}In_{0.5}P barrier layers with a thickness of 4 µm and five undoped Ga_{0.5}In_{0.5}P quantum well layers with a thickness of 6 nm, a Zn doped ( Al_{0.7}Ga_{0.3} )_{0.5}In_{0.5}P p-type clad layer with a thickness of 1.0 µm, and a p-type Ga_{0.5}In_{0.5}P hetero buffer layer are sequentially grown. The MOVPE method is used for crystal growth. The AlGaInP type layer is grown under the conditions that the V/III ratio is 55, the growth temperature is 660 °C, and the reaction chamber pressure is 70 Torr.

An SiO₂ mask with a width of 5 µm is formed in a form of stripes on the wafer using a conventional photolithography technique. A wet etching is conducted so as to remove the p-type (Al_{0.7}G_{0.3} )_{0.5}In_{0.5}P clad layer and the p-type Ga_{0.5}In_{0.5}P hetero-buffer layer leaving the p-type ( Al_{0.7}Ga_{0.3} )_{0.5}In_{0.5}P clad layer by 0.2 µm. Thereafter, a Si doped n-type GaAs block layer is selectively grown by the MOVPE method using SiO₂ as a mask. Then, the SiO₂ mask is removed, and a Zn doped p-type GaAs cap layer is formed. A p-type electrode and an n-electrode are finally formed.

In the MQW layer produced by this method, a flat layer is obtained and a threshold current of the semiconductor laser thus obtained is reduced to 35 from 40 mA, that is, the threshold current is reduced by about 15 % owning to an increase in a quantum size effect.

In the description of the foregoing embodiment, the description was made for the lattice matched growth of the AlGaInP type layer on the GaAs substrate. However, in cases such as a long wavelength band light emitting device formed of AlGaInAs type layer on an InP substrate, as well as a GaInAsP type layer on an InP layer, an improvement of a device characteristic such as a reduction in a threshold current and an increase in a two dimensional electron mobility can also be achieved. In addition, in cases where a strained AlGaInP type layer is formed on the foregoing GaAs substrate, and a strained AlGaInAs type layer on an InP substrate, and a stained GaInAsP type layer on the InP substrate, including an InAsP type layer on the GaAs substrate which is also a strained material, the same effects can be attained.

The crystal growth of these layers was described principally in the case of the MOVPE method. The material used at the time of the crystal growth are trimethyl alminium, triethyl gallium, trimethyl indium, phosphine, arsine, disilane, dimethyl zinc and the like. In addition, in the MBE method using arsine and phosphine as the group V material, and metals such as aluminum, gallium, and indium as the group III material, when the quantum well structure formed of the foregoing type of materials is grown under the conditions that the group V pressure is 0.5 to 2 × 10⁻⁵ Torr and a growth temperature is 450 to 500 °C, the height of the step bunching is reduced to about 1.5 nm compared with 2nm in the prior art. In other words, with respect to the degree of the flatness of the quantum well layer, the flatness is increased by 10 to 20 %.

Furthermore, although III-V compound semiconductor substrates were used in the above embodiments, the present invention is not limited to the group III-V compound semiconductor substrate. Other semiconductor substrates may be employed as long as a III-V compound semiconductor layer having a (11n)B plane ( n: integers from 3 through 7) is used as the growth surface orientation or in other words the direction of growth.

While the present invention has been described in connection with certain preferred embodiments, it is to be understood that the subject matter encompassed by way of the present invention is not to be limited to those specific embodiments. On the contrary it is intended for the subject mattter of the invention to include all alternatives, modifications and equivalents as can be included within the spirit and scope of the following claims.

## Claims

1. A method for growing a semiconductor crystal by a metal organic vapor phase epitaxy method, said method characterized in that a group III-V compound semiconductor layer is formed on a semiconductor substrate having a (11n)B surface (n= 3, 4, 5, 6, 7 ) as a growth plane orientation, wherein a ratio of a group V material supply to a group III material supply at a time of said growth of said group III-V compound semiconductor layer is 55 or less.

2. A method for growing a semiconductor crystal by a molecular beam epitaxial growth method, said method characterized in that a group III-V compound semiconductor layer is formed on a semiconductor substrate having a (11n)B surface ( n= 3, 4, 5, 6, 7 ) as a growth plane orientation, wherein a group V pressure within a growth apparatus at a time of said growth of said group III-V compound semiconductor layer is 2 × 10⁻⁵ Torr or less.

3. The method according to claim 1, wherein said growth plane orientation is (115)B.

4. The method according to claim 2, wherein said growth plane orientation is (115)B.

5. The method according to claim 1, wherein said group III-V compound semiconductor layer includes at least one quantum well structure composed of a barrier layer and a quantum well layer.

6. The method according to claim 2, wherein said group III-V compound semiconductor layer includes at least one quantum well structure composed of a barrier layer and a quantum well layer.

7. The method according to claim 5, wherein GaAs is used as said semiconductor substrate, ( AlₓGa₁₋ₓ )_{y}In_{1-y}P is used as said barrier layer, and ( Al_{x'}Ga_{1-x'} )_{y'}In_{1-y'}P is used as said quantum well layer, and 0<x, x', y, y'<1.

8. The method according to claim 6, wherein GaAs is used as said semiconductor substrate, ( AlₓGa₁₋ₓ )_{y}In_{1-y}P is used as said barrier layer, and ( Al_{x'}Ga_{1-x'} )_{y'}In_{1-y'}P is used as said quantum well layer, and 0<x, x', y, y'<1.

9. The method according to claim 5, wherein InP is used as said semiconductor substrate, ( AlₓGa₁₋ₓ )_{y}In_{1-y}As is used as said barrier layer, and ( Al_{x'}Ga_{1-x'} )_{y'}In_{1-y'}As is used as said quantum well layer, and 0<x, x', y, y'<1.

10. The method according to claim 6, wherein InP is used as said semiconductor substrate, ( AlₓGa₁₋ₓ )_{y}In_{1-y}As is used as said barrier layer, and ( Al_{x'}Ga_{1-x'} )_{y'}In_{1-y'}As is used as said quantum well layer, and 0<x, x', y, y'<1.

11. The method according to claim 5, wherein InP is used as said semiconductor substrate, GaₓIn₁₋ₓAs_{y}P_{1-y} is used as said barrier layer, and Ga_{x'}In_{1-x'}As_{y'}P_{1-y'} is used as said quantum well layer, and 0<x, x', y, y'<1.

12. The method according to claim 6, wherein InP is used as said semiconductor substrate, GaₓIn₁₋ₓAs_{y}P_{1-y} is used as said barrier layer, and Ga_{x'}In_{1-x'}As_{y'}P_{1-y}' is used as said quantum well layer, and 0<x, x', y, y'<1.

13. The method according to claim 5, wherein GaAs is used as said semiconductor substrate, AlₓGa₁₋ₓAs is used as said barrier layer, and Al_{x'}Ga_{1-x'}As is used as said quantum well layer, and 0<x, x'<1.

14. The method according to claim 6, wherein GaAs is used as said semiconductor substrate, AlₓGa₁₋ₓAs is used as said barrier layer, and Al_{x'}Ga_{1-x'}As is used as said quantum well layer, and 0<x, x'<1.

15. A semiconductor device comprising:
a group III-V compound semiconductor layer formed by a metal organic vapor phase epitaxy method on a semiconductor substrate having a (11n)B surface ( n= 3, 4, 5, 6, 7) as a growth plane orientation, said metal organic vapor phase epitaxy method utilizing a ratio of a group V material supply to a group III material supply not exceeding 55 at a time of growing said group III-V compound semiconductor layer.

16. A semiconductor device comprising:
a group III-V compound semiconductor layer formed by a molecular beam epitaxial growth method on a semiconductor substrate having a (11n)B surface ( n= 3, 4, 5, 6, 7) as a growth plane orientation, said molecular beam epitaxial growth method utilizing a group V pressure at a growth apparatus not exceeding 2 × 10⁻⁵ Torr at a time of growing said group III-V compound semiconductor layer.

17. The semiconductor device according to claim 15, wherein said growth plane orientation is (115)B.

18. The semiconductor device according to claim 16, wherein said growth plane orientation is (115)B.

19. The semiconductor device according to claim 15, wherein said group III-V compound semiconductor layer includes at least one quantum well structure comprising a barrier layer and a quantum well layer.

20. The semiconductor device according to claim 16, wherein said group III-V compound semiconductor layer includes at least one quantum well structure comprising a barrier layer and a quantum well layer.
